# EUROPEAN PATENT SPECIFICATION

(11) **EP 3 597 985 B1**
(45) Date of publication and mention of the grant of the patent: **11.10.2023**
(21) Application number: 19386031.9
(22) Date of filing: 14.06.2019
(51) Int. Cl.: F21S 9/03, F21V 33/00

(54) **LUMINOUS SMART PACKAGING WITH ENERGY AUTONOMY**
INTELLIGENTE LEUCHTENDE VERPACKUNG MIT ENERGIEAUTONOMIE
CONDITIONNEMENT INTELLIGENT LUMINEUX À AUTONOMIE D'ÉNERGIE

(30) Priority: 17.07.2018 GR 20180100324
(43) Date of publication of application: 22.01.2020
(73) Proprietor: Organic Electronic Technologies Private Company, 57001 Thermi, Thessaloniki (GR)
(72) Inventor: MEKERIDIS, Evangelos, 59032 Trikala Imathias (GR); TSIMIKLI, Sofia, 54248 Thessaloniki (GR); PECHLIVANI, Eleftheria-Maria, 56224 Thessaloniki (GR); KOKKINOS, Dimitrios, 54248 Thessaloniki (GR)
(74) Representative: Panagiotidou, Effimia

(56) References cited:
- WO-A1-2017/115281
- WO-A2-2012/162511
- DE-U1-202014 004 135
- US-A1- 2006 130 894
- US-A1- 2010 065 834
- US-A1- 2012 120 643
- US-A1- 2015 364 709

## Description

The present invention belongs to the category of inventions for the development and manufacture of smart packages. More particularly, the present invention relates to the development and manufacture of luminous smart packages.

The term "Smart Packaging" of the current state of the art means a package containing an external or internal index providing information on the packaging and / or the quality of the product it encloses. In particular, the term "luminous smart packaging" defines intelligent light-packs from light sources.

Luminous smart packages of the prior art, to meet their energy needs, use at least one or more batteries and / or an energy storage element, such as a capacitor, to power the light sources. This means that if the battery and / or the energy storage element is depleted, smart packaging ceases to be functional and intelligent, not having the energy autonomy to continuously cover the operation of the light sources for light emission.

Regarding prior art, luminous smart packaging comprises light sources like LEDs, Organic Light Emitting Diodes- OLEDs, organic electrochromic luminous diodes- OLECs and / or electrochromic LECs. These inventions are described both in documents WO2015147995A1, CN202264993U and original product applications on the market. All these inventions face the problem of energy autonomy, since the depletion of the battery or energy storage element is inevitable when light is emitted from the light sources over time. The replacement of the battery with a new one with energy self-sufficiency for some months, or the withdrawing of the smart package to charge the energy storage element or the batteries if they are rechargeable, via DC-to-AC or alternating AC voltage.

The disadvantages of the above-mentioned solutions of the current state of the art are that all of these in order to be implemented require human intervention which means cost to pay for workers who will replace or charge the battery or the energy storage element, costs for purchasing a new battery for replacement, the cost of the power to be consumed to charge their capacitor or the batteries if they are rechargeable, burden on the environment since the batteries are not recyclable, as well as a waste of time when removing and replacing the packages in the storage areas, such as on department stores shelves. On the other hand, as described in document WO2015147995A1, the charging of batteries and / or energy storage elements can be achieved without cables based on the effect of electromagnetic induction. The inductive charging to be realized also requires human intervention to place the package on a charging base carrying an induction coil and constitutes the charging station. The package must also carry a second inductive coil that receives energy from the electromagnetic field that generates the first one and converts it into electrical energy.

However, the last years recent documents have proposed luminous devices with energy autonomy systems. These innovations combine light emitting diodes as light sources and Organic Photovoltaics (OPVs) devices (modules or cells) providing power to the components of the luminous device. Document US 2015/364709 A1 has presented energy harvesting capabilities from primary packaging, comprising OPV cells. In addition, it is already known by the Documents WO 2017/115281 A1 and US 2010/0065834 A1 light-emitting devices that do not require an external power source because they incorporate OPVs which produce electricity to directly power OLED devices, while in documents US 2006/0130894 A1 and US 2012/0120643 A1 solar-powered illumination devices also include electric energy storage elements (battery or capacitor) for storing charge from the generated electricity and a controller that regulates the current transmitted between the components. The invention uses the already known technology of OPVs. However, applications using OPVs as a power generation system for the supply of smart packaging have not been known to date and are not part of the current state of the art.

The invention is a method for shadow detection following claim 1. The method is Z performed by the luminous smart package. In the present invention the luminous smart package is based on the development and construction of a shadow detection system that activates the light sources when, due to an obstacle in front of the OPV device shading change occurs, resulting in less charging power in a capacitor. In this smart packaging, OPV devices act as both the energy provider of the system to ensure energy autonomy and as the shadow detector. More specifically, the electronic circuit of the shadow detection system takes all its energy from at least one OPV device and stores it in a small dimensions capacitor. Then the light indicator from the light sources is off. The smart packaging works by performing a shading change detection method. Once the shading change has been detected, the smart packaging is light emitting. Reduction in shading can be caused when an obstacle, such as an object and / or human presence, is found in front of the package where the OPV device is located. The obstacle causes shading in the OPV device, the electronic circuit senses through its microprocessor the reduction of incident light irradiation and gives power from the capacitor to the light sources, leading them to strong flashing. At this point, the same OPV device, apart from playing the role of the energy charger, also operates as a shading detector since it is quite sensitive in the change of incident light irradiation.

Furthermore, the use of OPVs as energy provider in luminous smart packaging eliminates any need for continuous battery replacement after a period of time, since they provide a continuous charge to the storage components as well as possible damage to the packaging itself when replacing the battery, avoiding the drawbacks of the current state of the art.

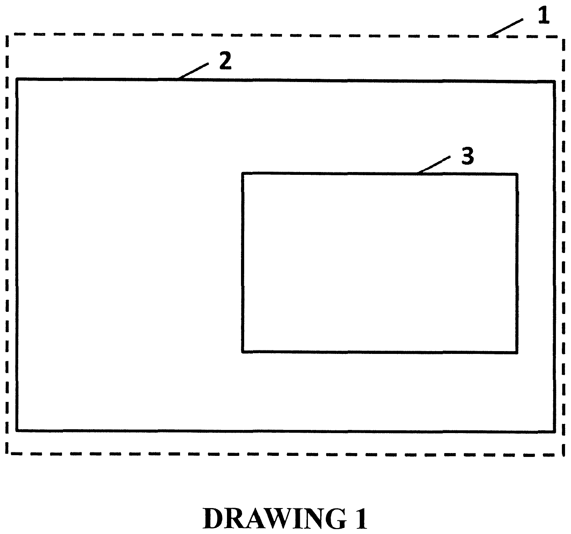

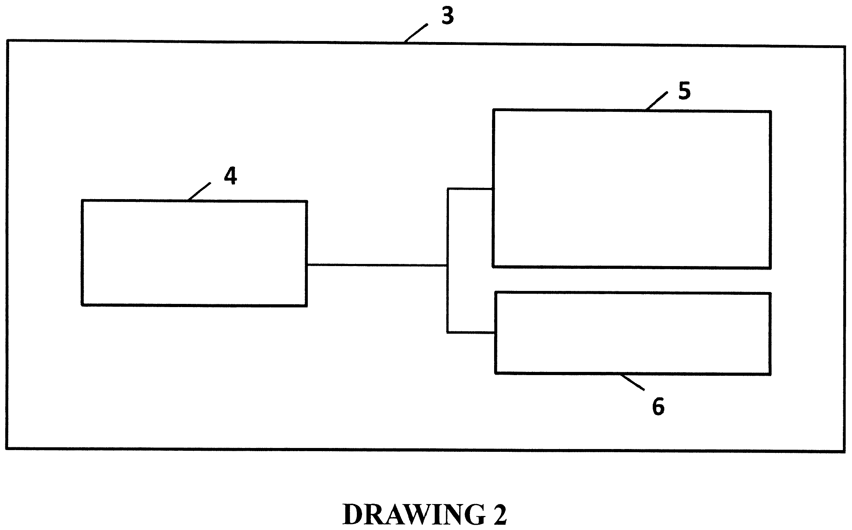

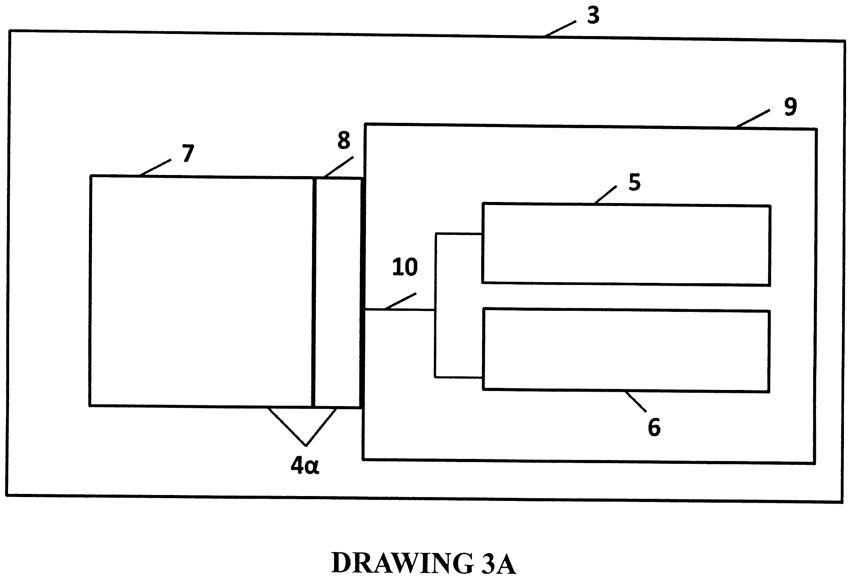

The Drawings which accompany the invention briefly illustrate the following:
Drawing 1 illustrates a luminous smart package, which consists of a product package incorporating a shadow detection system.
Drawing 2 illustrates the shadow detection system, which consists of three main parts: a small-dimensional electronic circuit, an OPV device and one and / or more light sources.
Drawing 3A illustrates the shadow detection system, which consists of a PCB- printed circuit board accomplished with pressure terminals which are coupled through printed conductive electrodes with a flexible plastic substrate carrying an OPV device and one and / or more light sources.
Drawing 3B illustrates the shadow detection system, which consists of a fully printed circuit board connected via printed conductive electrodes to a flexible plastic substrate carrying an OPV device and one and / or more light sources.
Drawing 4 illustrates the electronic circuit of Drawings 3A and 3B, which consists of a capacitor, a microprocessor with terminals and a load control/management circuit.
Drawing 5 illustrates the shadow detection system of Drawings Figure 3A, consisting of a printed circuit board-PCB which is connected using five pressure terminals to the printed conductive electrodes connecting an OPV device and two light sources on a flexible plastic substrate. Drawing 6 illustrates the flow chart of the shadow detection method performed by the luminous smart package.
Drawing 7 illustrates a mode of implementation of a luminous smart package.

The invention is described in detail below by way of a non-limitative example and with reference to the accompanying drawings which show embodiments the present invention as depicted more particularly in drawings 3A and 5.

As illustrated in Drawing 1, in a mode of implementation of a luminous smart package (1), the package (1) is consisted of a product package (2) integrating to the surface interior a functional shadow detection system with energy autonomy (3). The product package (2) which integrates the shadow detection system (3) can be any of the prior art packaging materials, such as, for example, a paper, metal and / or plastic box and even glass such as a bottle, etc. The luminous smart package (1) due to the fact that OPVs operate in low light conditions up to 1000 lux, is intended for indoor use utilizing interior lighting.

As illustrated in Drawing 2, the shadow detection system (3) consists of three main parts: a small dimension electronic circuit (4), an OPV device (5) and one and / or more light sources (6). The light sources can be LEDs, OLEDs, OLECs and / or LECs in various sizes, shapes and colors. Similarly, the shape, size and color of the printed OPVs is determined according to the features and graphics of the packaging in which they are integrated and/ or to the needs of the electronic circuit. OPVs can be printed on a large scale by printing techniques such as Flexography, gravure, Inkjet, and/ or Screen printing on inverted and/ or normal architectural structures onto flexible substrates such as Polyethylene terephthalate -PET or directly on the packaging material if it is plastic or / and paper. The color of OPVs is determined by the materials that are mixed to create their photoactive layer and their pattern design is formed using various techniques such as laser, photolithography or chemical etching.

The electronic circuit (4) of the shadow detection system (3) as illustrated in Drawing 3A and 3B may be either a PCB printed circuit board (7) (drawing 3A) and / or a fully printed circuit board (11) (Drawing 3B) from conductive inks printed using printing techniques directly on the surface of the packaging material or on a bearing plastic substrate (9).

More specifically, Drawing 3A depicts the shadow detection system (3) consisting of an electronic circuit (4a) from a printed circuit board-PCB (7) attached with pressure terminals (8). The pressure terminals (8) hold a flexible bearing plastic substrate (9) to which an OPV device (5) and one and / or more light sources (6) are printed or attached. Conductive electrodes (10) which are printed on the bearing plastic substrate (9) interconnect the OPV device (5) and the light sources to the PCB (7) via the pressure terminals (8).

In the case where the electronic circuit (4b) is a fully printed circuit board (11), as shown in Drawing 3B, no pressure terminals (8) are needed because the circuit itself is printed on the bearing plastic substrate (9), with printed conductive electrodes (10) which are connected to the terminals of the OPV device (5) and one and / or more light sources (6) onto the substrate (9) thereof. The fully printed circuit board (11) can be printed on the bearing plastic substrate (9) by inkjet and gravure printing techniques while the conductive electrodes (10) can be printed on the substrate (9) by using ink and screen printing.

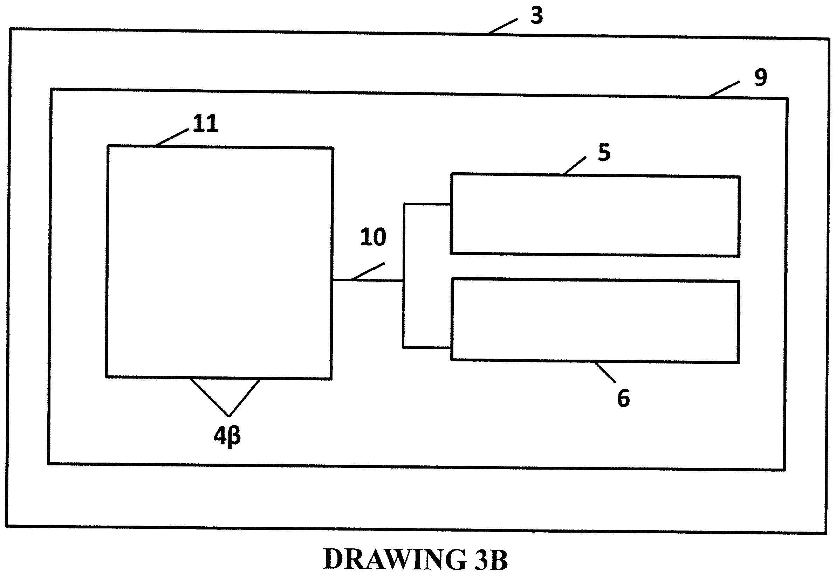

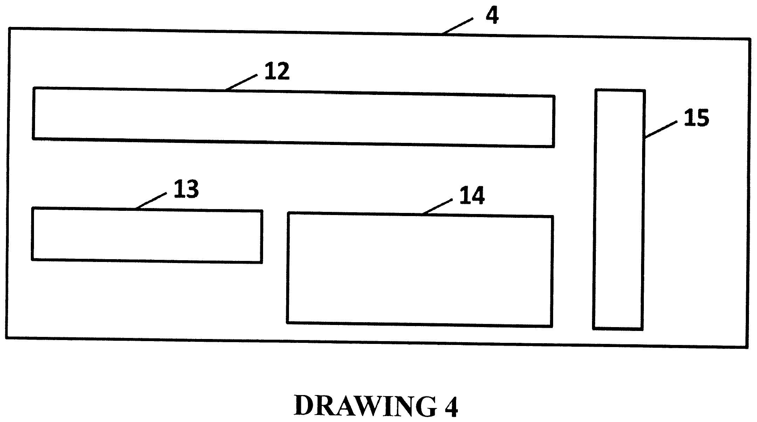

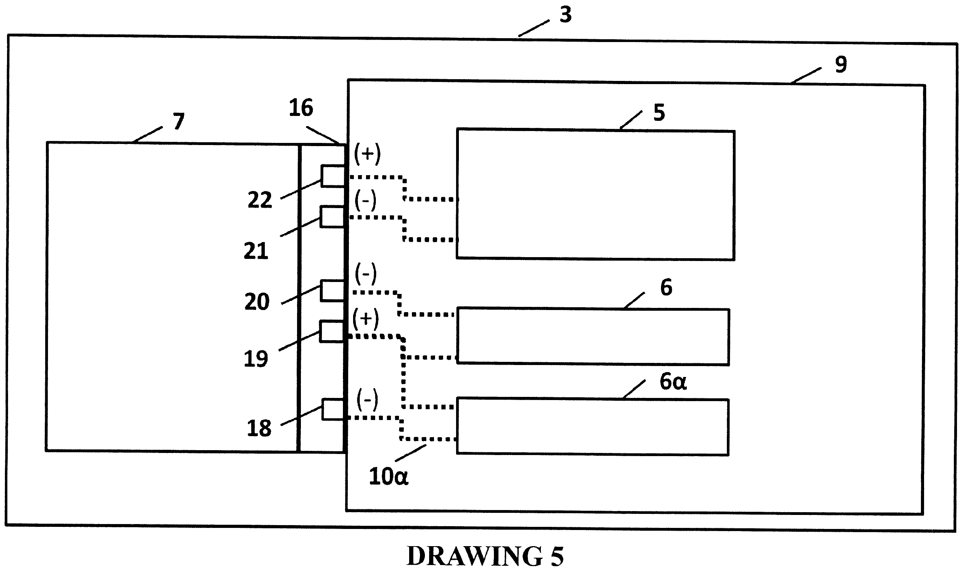

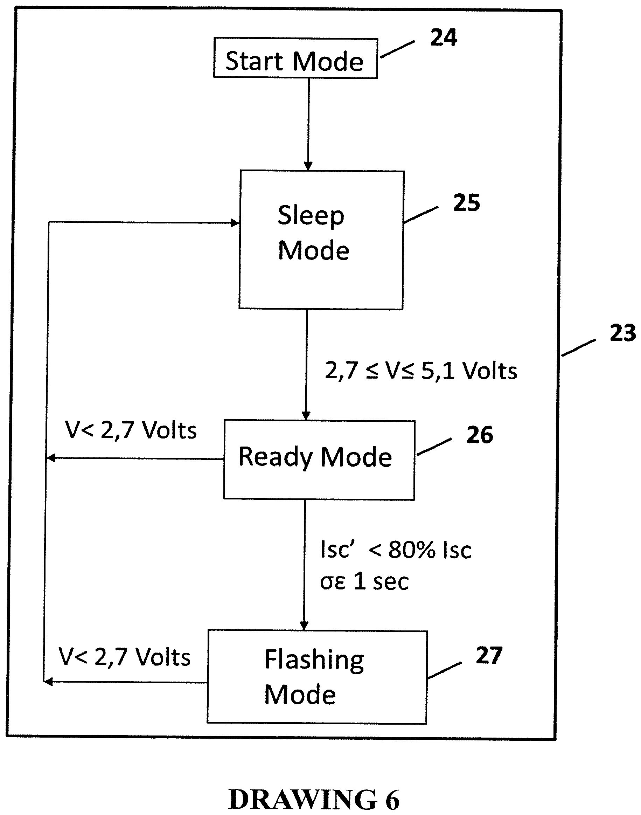

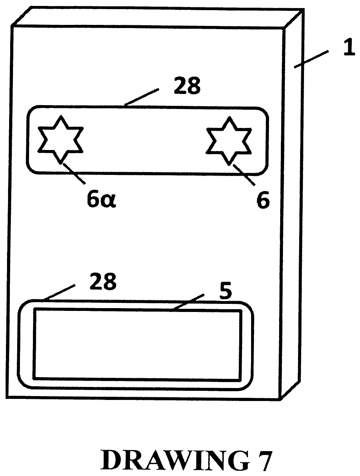

The electronic circuit (4) illustrated in Fig. 4 consists of individual components such as a capacitor (12), a microprocessor (13) with terminals (15) for proper programming, and a load control circuit (14). In the case of the electronic circuit (4a) of Drawing 3A, the individual components are connected to each other by conductive metallic corridors of copper and / or silver and are integrated to the PCB by hotmelt using Tin. On the other, in Fig. 3B, the individual components constituting the electronic circuit (4b) are connected to each other by silver printed conductive electrodes and attached to the circuit (4b) by electrochromic and/ or electrostatic methods.

The load control circuit (14) consists of individual capacitors, resistors and diodes. Depending on the supplied and consumed power and voltage, the load control circuit (14) manages the charging and discharging of the capacitor (12), compensating for the voltages between the OPV (5) and the light sources (6) and the microprocessor (13). The operation of the shadow detection system (3) is based on the fact that the OPV device (5) harvest the light energy and converts it into electrical energy and transfers it through the conductive printed electrodes (10) to the electronic circuit (4) by storing the electrical energy to a capacitor (12). By using OPVs (5), the energy autonomy of the shadow detection system (3) is assured, as the OPVs continuously cover the energy losses of the electronic circuit (4) for activating the light sources (6) and replenish the energy consumed by the light sources when flashing.

Drawing 5 shows a shadow detection system consisting of an electronic circuit (4) based on a printed circuit board (7) connected by pressure terminals (8) to a flexible plastic substrate (9) carrying an OPV device (5) and two light sources (6 and 6a). Of course, the present invention is applied in a similar way in the case where the light sources are one and/ or more. Five pressure terminals (16) are integrated by gluing to the board (7) and connected to five printed conductive electrodes (10a), whilst the first terminal (18) is connected to the anode of the second light source (6a), the second terminal (19) is connected to the cathode of the second light source (6a) and of the first light source (6), the third terminal (20) at the anode of the first light source (6), the fourth terminal (21) at the negative terminal of the OPV (5) and the fifth terminal (22) to the positive terminal of the OPV (5).

The shadow detection method is performed by the luminous smart package (1) according to the following steps.

The shadow detection system for optimal operation performs a method illustrated in Flow chart (23) of Drawing 6. The flow chart of the shadow detection method (23) of the luminous smart package (1) is based on four operating modes: a) starting mode (24), b) sleep mode (25), c) ready mode (26) and d) the flashing mode.

In the luminous smart package (1) when the OPV is being shaded (5), the microprocessor (12) of the electronic circuit (4) senses via the voltage value the reduction of the incident light radiation and gives power from the capacitor (13) to the light sources (6) leading them to strong flashing.

The voltage Vₒₚ of the light sources (6) of the luminous smart packaging (1) ranges from 2.7 Volt to 5.1 Volt. The electronic circuit (7) has a current consumption of 100 µA with a minimum voltage for its operation at 2.7 Volt. Since the luminous smart packaging is intended to be used indoors, OPV (5) should provide this power under indoor lighting conditions. It is preferred, the OPV to have a high open circuit voltage at 12 Volt in order to provide the required power with little light. The LED lights to illuminate at an indoor lighting space require a voltage slightly above the minimum of 2.7Volt of the voltage of the electronic circuit (7), whereas they need a voltage of up to 5 Volts in order to light intensively. For this reason, inside the load control circuit (14) is contained a Zener diode for blocking the OPV voltage at 5.1 Volts.

The luminous smart packaging (1) is set to starting mode (24) when is placed in indoor lighting conditions. As the microprocessor (12) of the shadow detection system (3) is at a low power output of less than 2.7 Volts, the light sources (6) remain in sleep mode (25). When the capacitor (13) voltage exceeds the minimum required operating voltage of 2.7 Volts, then the first light source (6) is activated every 10 seconds to light up for 3 msec. This state is characterized as a ready mode (26).

During ready mode, the PCB electronic circuit (7) shortens the OPV (5) every 1 sec to measure the short circuit current Isc. The maximum value that can be measured is 1mA. The maximum current value that can be measured depends on the performance of the OPV device (5), the intensity of the light radiation and where is placed the luminous smart packaging (1) in terms of the ambient light in which it is located. If the current is higher than the measurement will be saturated to 1mA. If the value of the Isc is measured 20% less than the previous one due to shading, then the luminous smart packaging (1) goes into flashing mode, where the light sources (6) and (6a) are flashing.

Finally, in both operation modes, ready mode (25) and flashing (26), if the capacitor voltage drops down the 2.7 Volts, the luminous smart package (1) returns to the sleep mode (25).

The present invention that is illustrated as a non-limiting example in Drawing 5, is similarly applied in the case where the OPV device (5) has a different size and performance and depending on what type are the light sources (6) LEDs, OLEDs, OLECs and/or LECs. In this case, the electronic circuit (4) shows a different sensitivity since operating parameters such as the minimum operating voltage, peak current Isc and light sources (6) activation time diversify in ready mode.

Drawing 7 illustrates the luminous smart package (1) in the case it is consisted of a paper box with an open window (28), such as in food packaging, does not require drilling it for inserting the OPV device and light sources. Also, if the window (28) is not opened but covered by a fixed film, then the entire flexible substrate (9) bearing the printed circuit (11) with the printed electrodes, the OPV device (5) and the light sources (6) easily enters beneath the film following the art graphics of the packaging. If the light sources (6) are not LEDs but OLEDs and/ or LECs then it is not necessary to drill film in points as required in the case of LEDs for extraction. Since film needs to be transparent to allow light to be harvested by OPVs, film is made from transparent materials, sheets of thickness < 60 µm, such as PP, PE and PVC, with PP having the greatest optical transparency and be the most easily manageable compared to the other two transparent materials during packaging development.

The industrial application of the invention targets the packaging and products' labeling industry. The illumination effect through the luminous packaging (1) can be activated without contact by shading an OPV (5) without using usual sensors on request, and with energy autonomy at places under indoor lighting such as department stores.

The application of printed OPVs in the packaging and label sector to ensure the energy autonomy of both light sources and sensors is imposed by the market not only because of their low cost of production since are produced over large area using Roll to Roll printed processes, but also to the high added value that offer to existing commercial packages. The OPVs are manufactured by multiple nanostructures of organic and inorganic materials with printing techniques (such as Flexography, Rotogravure, Inkjet printing, Slot die coating, Screen printing) that are widely used in the conventional flexographic printing industry, packaging film and labels. Industrial printers for manufacturing packaging layers and labels that print at high speeds and in large quantities have the ability with the appropriate modification for nanostructure production capability, also to be used for printing OPV devices. This gives the advantage to the current technology of printed OPVs to integrate faster, cheaper and simpler than any other conventional electronics technology in the packaging industry.

## Claims

1. A shadow detection method performed by a luminous smart package (1) consisting of a product package (2) incorporating a shadow detection system (3), the shadow detection system (3) integrates:
- light sources (6,6a) powered by Organic Photovoltaic Devices OPVs (5),
- a small dimension electronic circuit (4) which comprises a capacitor(12), a microprocessor (13) and a load control circuit (14),
- a printed circuit board (PCB) (7) with pressure terminals (8) connected through printed conductive electrodes (10) with a flexible plastic substrate (9) carrying an OPV device (5) and light sources (6,6a) such as Light Emitting Diodes (LEDs), Organic Light Emitting Diodes (OLEDs) and electrochromic (LECs),
**characterized in that**
the luminous smart package (1) performs the flow chart of the microprocessor program (12) of its electronic circuit (4) based on four operating modes:
a) starting mode (24), b) sleep mode (25), c) ready mode (26) and d) flashing mode and is performed by the following steps:
a) The luminous smart packaging (1) is set to starting mode (24) when is placed in indoor lighting conditions;
b) as the microprocessor (12) of the shadow detection system (3) is at a low power output of less than 2.7 Volts, the light sources (6,6a) remain in sleep mode (25);
c) when the capacitor (13) voltage exceeds the minimum required operating voltage of 2.7 Volts, then the first light source (6) is activated every 10 seconds to light up for 3 msec, being in ready mode (26), during which, the PCB electronic circuit (7) shortens the OPV (5) every 1 sec to measure the short circuit current Isc, the maximum value that can be measured being 1 mA;
d) if the current is higher than the measurement, it will be saturated at 1 mA and if the value of the Isc is measured 20% less than the previous one due to shading, then the luminous smart packaging (1) goes into flashing mode, where the light sources (6) and (6a) are flashing;
finally, in both operation modes, ready mode (25) and flashing (26), if the capacitor voltage drops down the 2.7 Volts, the luminous smart package (1) returns to the sleep mode (25).

## Patentansprüche

1. Ein Schattenerkennungsverfahren, das von einer leuchtenden intelligenten Verpackung (1) durchgeführt wird, die aus einer Produktverpackung (2) besteht, die ein Schattenerkennungssystem (3) enthält, wobei das Schattenerkennungssystem (3) Folgendes integriert:
- Lichtquellen (6,6a), die mit organischen Photovoltaikgeräten (OPVs) (5) betrieben werden,
- eine kleine elektronische Schaltung (4), die einen Kondensator (12), einen Mikroprozessor (13) und eine Laststeuerschaltung (14) umfasst,
- eine Leiterplatte (PCB) (7) mit Druckanschlüssen (8), die über gedruckte leitende Elektroden (10) mit einem flexiblen Kunststoffsubstrat (9) verbunden sind, das ein OPV-Gerät (5) und Lichtquellen (6,6a) trägt, wie lichtemittierende Dioden (LEDs), organische Leuchtdioden (OLEDs) und elektrochrom (LECs),
**dadurch gekennzeichnet, dass** das leuchtende intelligente Paket (1) das Ablaufdiagramm des Mikroprozessorprogramms (12) seiner elektronischen Schaltung (4) auf Grundlage von vier Betriebsmodi durchführt:
a) Startmodus (24), b) Schlafmodus (25), c) Bereitschaftsmodus (26) und d) Blinkmodus und wird durch die folgenden Schritte durchgeführt:
a) Die leuchtende intelligente Verpackung (1) wird in den Startmodus (24) versetzt, wenn sie in Innenbeleuchtungsbedingungen platziert wird;
b) da der Mikroprozessor (12) des Schattenerkennungssystems (3) eine niedrige Ausgangsleistung von weniger als 2,7 Volt aufweist, bleiben die Lichtquellen (6,6a) im Schlafmodus (25);
c) wenn die Spannung des Kondensators (13) die minimal erforderliche Betriebsspannung von 2,7 Volt überschreitet, dann wird die erste Lichtquelle (6) alle 10 Sekunden aktiviert, um für 3 ms zu leuchten, wobei sie sich im Bereitschaftsmodus (26) befindet, währenddessen die elektronische Schaltung (7) der Leiterplatte das OPV (5) alle 1 Sekunde verkürzt, um den Kurzschlussstrom (Isc) zu messen, wobei der maximale Wert, der gemessen werden kann, 1 mA beträgt;
d) wenn der Strom höher als die Messung ist, wird bei 1 mA gesättigt, und wenn der Wert des Isc aufgrund der Schattierung um 20 % niedriger als der vorherige gemessen wird, geht die leuchtende intelligente Verpackung (1) in den Blinkmodus über, in dem die Lichtquellen (6) und (6a) blinken;
schließlich, in beiden Betriebsmodi, Bereitschaftsmodus (25) und Blinkmodus (26), wenn die Kondensatorspannung um 2,7 Volt abfällt, kehrt die leuchtende intelligente Verpackung (1) in den Schlafmodus (25) zurück.

## Revendications

1. Procédé de détection d'ombre mis en oeuvre par un boîtier intelligent lumineux (1) constitué d'un boîtier (2) incorporant un système de détection d'ombre (3), le système de détection d'ombre lui-même (3) intégrant :
- des sources lumineuses (6,6a) alimentées par des dispositifs photovoltaïques organiques (DPO) (5),
- un circuit électronique de petite dimension (4) qui comprend un condensateur (12), un microprocesseur (13) et un circuit de commande de charge (14),
- une carte de circuit imprimé (CCI) (7) avec des bornes de pression (8) connectées à travers des électrodes de conduction imprimées (10) avec un substrat en plastique flexible (9) portant un dispositif DPO (5) et des sources lumineuses (6,6a) telles que des diodes électroluminescentes (LED), des diodes électroluminescentes organiques (OLED) et électrochromes (LEC),
**caractérisé en ce que**
le boîtier intelligent lumineux (1) réalise le diagramme de flux du programme microprocesseur (12) de son circuit électronique (4) en fonction de quatre modes de fonctionnement :
a) mode de démarrage (24), b) mode veille (25), c) mode prêt (26) et d) mode clignotant et est effectué par les étapes suivantes :
a) Le boîtier intelligent lumineux (1) est réglé sur le mode de démarrage (24) lorsqu'il est placé dans des conditions d'éclairage intérieur ;
b) comme le microprocesseur (12) du système de détection d'ombre (3) est à une sortie de faible puissance inférieure à 2,7 volts, les sources lumineuses (6,6a) restent en mode veille (25) ;
c) lorsque la tension du condensateur (13) dépasse la tension de fonctionnement minimale requise de 2,7 Volts, la première source lumineuse (6) est activée toutes les 10 secondes pour s'allumer pendant 3 msec, étant en mode prêt (26), pendant lequel, le circuit électronique CCI (7) met le DPO en court-circuit (5) à chaque seconde pour mesurer le courant de court-circuit (Isc), la valeur maximale pouvant être mesurée étant de 1 mA ;
d) si le courant est supérieur à la mesure, il sera saturé à 1 mA et si la valeur de l'Isc est inférieure de 20% par rapport à la précédente en raison de l'ombrage, alors le boîtier intelligent lumineux (1) passe en mode clignotant, où les sources lumineuses (6) et (6a) clignotent ;
enfin, dans les deux modes de fonctionnement, mode prêt (25) et clignotant (26), si la tension du condensateur chute en dessous de 2,7 volts, le boîtier intelligent lumineux (1) revient au mode veille (25).
